# FASCICULE DE BREVET EUROPEEN

(11) **EP 2 572 374 B1**
(45) Date de publication et mention de la délivrance du brevet: **02.10.2019**
(21) Numéro de dépôt: 11720488.3
(22) Date de dépôt: 19.05.2011
(51) Int. Cl.: C23F 1/02, H01L 21/687

(54) **PROCÉDÉ DE RÉALISATION D'UN SUPPORT DE SUBSTRAT**
VERFAHREN ZUR HERSTELLUNG EINER SUBSTRATHALTERUNG
METHOD FOR BUILDING A SUBSTRATE HOLDER

(30) Priorité: 21.05.2010 FR 1053987
(43) Date de publication de la demande: 27.03.2013
(73) Titulaire: Commissariat à l'Énergie Atomique et aux Énergies Alternatives, 75015 Paris (FR)
(72) Inventeur: FOURNEL, Frank, F-38190 Villard-bonnot (FR); BALLY, Laurent, F-38450 SAINT-GEORGES-DE-COMMIERS (FR); ZUSSY, Marc, F-38120 Saint Egreve (FR); JOURDE, Dominique, F-38180 Seyssins (FR)
(74) Mandataire: Ilgart, Jean-Christophe
(86) Numéro de dépôt international: PCT/EP2011/058119
(87) Numéro de publication internationale: WO 2011/144687

(56) Documents cités:
- WO-A2-2004/015727
- US-A1- 2003 047 283
- US-A1- 2006 075 969
- US-A1- 2007 040 265
- US-A1- 2007 138 601

## Description

### DOMAINE TECHNIQUE

L'invention concerne le domaine des supports (« holder » en anglais) de substrat, ou wafer, par exemple utilisés en microélectronique lorsque l'on souhaite mettre en oeuvre des opérations technologiques (dépôt de matériau, gravure, etc.) sur un substrat dont la petite taille n'est pas adaptée à la ou aux machines réalisant ces opérations technologiques.

### ÉTAT DE LA TECHNIQUE ANTÉRIEURE

On désigne par "holder", ou support de substrat, un dispositif qui permet, dans une machine normalement utilisée pour des substrats, ou plaques, de diamètre D₁, d'utiliser cette machine pour des substrats de diamètre D₂ inférieur à D₁. Par exemple, dans une machine de dépôt par CVD (dépôt chimique en phase vapeur) qui généralement utilisée pour réaliser des dépôts sur des substrats de 300 mm de diamètre, il est possible, avec un tel support de substrat, de réaliser des dépôts sur un substrat de diamètre inférieur ou égal à 200 mm sans avoir à effectuer de changement de configuration de la machine.

Il existe plusieurs méthodes pour réaliser de tels supports de substrat. Par exemple, il est possible de creuser, dans un substrat de diamètre D₁, un emplacement, ou empreinte, de diamètre D₂, avec D₂ < D₁. Ainsi, il est possible de disposer un substrat de diamètre D₂ dans cet emplacement. Cet emplacement peut être réalisé par photolithographie et gravure ionique et/ou chimique dans le substrat de diamètre D₁. Il est également possible de réaliser un tel emplacement avec une machine d'amincissement mécanique comportant une roue de rectification spécifiquement conçue pour roder le centre d'un substrat en conservant un bord extérieur du substrat qui formera le bord de l'emplacement dans lequel sera disposé le substrat de diamètre D₂.

Toutefois, une telle réalisation de support de substrat pose plusieurs problèmes. Tout d'abord, l'emplacement doit être assez profond pour que le substrat de diamètre D₂ ne sorte pas facilement de l'emplacement. Cette profondeur doit donc être au moins égale à la moitié de l'épaisseur du substrat de diamètre D₂ en raison du double chanfrein se trouvant sur le bord périphérique du substrat qui pourrait le faire sortir de l'emplacement en cas de mouvement brusque. Cela a pour conséquence que l'épaisseur du support au niveau de l'emplacement, c'est-à-dire entre le fond de l'emplacement et la face arrière du support, est relativement mince, ce qui peut poser des problèmes de tenue mécanique du support.

Par exemple, pour traiter un substrat de silicium de diamètre égal à 200 mm et d'épaisseur égale à 725 µm dans une machine qui traite normalement des substrats de diamètre égal à 300 mm et d'épaisseur égale à 750 µm, un emplacement de diamètre légèrement supérieur à 200 mm et de profondeur égale à 350 µm est réalisé dans un substrat de diamètre égal à 300 mm et d'épaisseur égale à 750 µm. Dans ce cas, l'épaisseur de la paroi de fond de l'emplacement est égale à 400 µm. Avec un tel emplacement, le substrat de diamètre égal à 300 mm présente une flexibilité importante pouvant provoquer une déformation trop importante du substrat qui est disposé dans l'emplacement lors, par exemple, des étapes de chargement et de déchargement effectuées par certains robots, rendant son utilisation impossible avec certaines machines. Cette faible épaisseur restante de matériau au niveau de la paroi de fond de l'emplacement peut également fragiliser très fortement le support et entraîner une casse du support lors de sa manipulation.

Par ailleurs, la réalisation d'un tel emplacement par gravure dans un substrat destiné à former le support rend difficilement contrôlable la rugosité, la planéité et la propreté des parois de l'emplacement. Par exemple, lorsque l'emplacement est réalisé par une machine d'amincissement mécanique, il se forme, en surface du matériau rodé, une zone écrouie de quelques micromètres d'épaisseur qui peut être une source très importante de particules, rendant ces supports incompatibles avec une utilisation en salle blanche. Lorsque l'emplacement est réalisé par photolithographie et gravure chimique ou ionique, la rugosité et la planéité de la surface traitée sont très difficilement contrôlables car il est impossible de rectifier ensuite la rugosité et la planéité de la surface réalisée (paroi de fond de l'emplacement) par les techniques classiques de polissage mécano-chimique.

Il est également possible de réaliser des supports de substrat en collant par exemple sur la surface d'un substrat de diamètre D₁ des portions de matériaux destinées à bloquer le substrat de diamètre D₂ lorsqu'il est disposé entre ces portions de matériaux. Toutefois, un tel procédé pose des problèmes de reproductibilité du positionnement des pièces et de tenue en température de la colle utilisée, celle-ci devant ne pas se dégrader au cours des étapes de traitement du substrat de diamètre D₂.

Le document US 2007/0040265 A1 divulgue un support de substrat multicouche et une méthode de réalisation dudit support.

### EXPOSÉ DE L'INVENTION

Un but de la présente invention est de proposer un nouveau procédé de réalisation d'un support de substrat ne présentant pas les inconvénients des procédés de l'art antérieur, c'est-à-dire permettant de réaliser un support de substrat présentant une bonne rigidité, avantageusement une très bonne tenue en température, par exemple jusqu'à des températures égales à environ 1350°C, une absence de contamination particulaire sur sa surface, une très bonne rugosité et une très bonne planéité de la surface sur laquelle le substrat destiné à être supporté est disposé, et présentant une très bonne reproductibilité en termes de positionnement du substrat destiné à être supporté.

Pour cela, l'invention propose un procédé de réalisation d'un support d'au moins un substrat, comportant au moins la mise en oeuvre des étapes suivantes :
- réalisation d'un empilement comportant au moins deux substrats, chacun des deux substrats comprenant deux faces principales opposées, les deux substrats étant solidarisés l'un à l'autre tels qu'une des faces principales d'un premier des deux substrats soit disposée en regard d'une des faces principales du second des deux substrats et contre un matériau d'arrêt de gravure,
- gravure, à travers le premier des deux substrats et avec arrêt sur le matériau d'arrêt de gravure, d'au moins un emplacement apte à recevoir le substrat destiné à être supporté par le support.

Un tel procédé permet de réaliser un support de substrat avec un très bon contrôle de la profondeur de l'emplacement destiné à recevoir le substrat à supporter puisque cette profondeur est égale au moins à l'épaisseur d'un des deux substrats utilisés pour former le support. La profondeur souhaitée peut donc être ajustée en choisissant le premier substrat (celui à travers lequel l'emplacement est réalisé) plus ou moins épais. Etant donné que l'emplacement est réalisé par gravure à travers ce premier substrat, ce procédé offre donc une bonne reproductibilité en termes de profondeur et de positionnement de l'emplacement.

De plus, ce support présente une bonne rigidité en raison du second substrat dont l'épaisseur est constante sur l'ensemble du support, l'emplacement n'étant pas gravé dans ce second substrat.

Le procédé selon l'invention permet également d'obtenir un très bon contrôle de la propreté (en termes de contamination particulaire), de la planéité et de la rugosité de la paroi de fond de l'emplacement car la gravure de l'emplacement est réalisée avec arrêt sur le matériau d'arrêt de gravure.

La rugosité de la paroi de fond de l'emplacement ainsi réalisé peut même être suffisamment faible pour permettre le collage par capillarité ou par collage direct du substrat qui est disposé dans l'emplacement. Cette possibilité de collage permet donc, lors de la réalisation d'opérations de traitement du substrat disposé dans l'emplacement du support, de positionner le support à la verticale, voir même de le retourner pendant le transport et/ou le traitement du substrat, et ce sans être obligé de rajouter des éléments de maintien au niveau de la face avant du substrat traité. Ainsi, l'ensemble de la face avant du substrat qui est disposé dans l'emplacement reste accessible, même lorsque le support est retourné.

Le terme « substrat », qui est équivalent aux termes « wafer », « plaque », « plaquette », ou encore « couche », désigne à la fois l'objet destiné à être supporté par le support selon l'invention et qui est désigné par l'expression « substrat destiné à être supporté par le support », et les couches servant à la réalisation du support selon l'invention et qui sont désignées par l'expressions « deux substrats ».

Avantageusement, les deux substrats peuvent être solidarisés par un collage direct ou par un collage anodique ou par un collage eutectique. Un tel collage des substrats permet d'améliorer la résistance du support à la température, qui peut dans ce cas être exposé à des hautes températures, voir de très hautes températures (de l'ordre de 1350°C pour des substrats de silicium), notamment dans le cas d'un collage direct ou d'un collage anodique. Cette tenue en température du support permet donc de mettre en oeuvre sur le substrat, destiné à être supporté par le support, des étapes technologiques à de telles températures telles que des étapes d'épitaxies.

Les deux substrats peuvent avoir des épaisseurs sensiblement similaires et/ou des sections, dans un plan sensiblement parallèle à l'une des faces principales des deux substrats, de dimensions sensiblement similaires.

Les deux substrats peuvent avoir des sections, dans un plan parallèle à l'une des faces principales des deux substrats, en formes de disques, une section de l'emplacement, dans un plan parallèle à l'une des faces principales des deux substrats, pouvant avoir une forme de disque de diamètre inférieur aux diamètres desdites sections des deux substrats. Ainsi, le support peut être réalisé à partir de substrats standards sous forme de plaquettes (wafer) cylindriques.

Le premier des deux substrats peut être à base d'au moins un matériau apte à être gravé sélectivement par rapport à au moins un matériau du second des deux substrats formant le matériau d'arrêt de gravure. Ainsi, le second des deux substrats peut former une couche d'arrêt de gravure lors de la réalisation du support.

En variante, l'empilement peut comporter en outre une couche d'arrêt de gravure disposée entre les deux substrats.

Dans ce cas, l'empilement peut être réalisé par la mise en oeuvre des étapes suivantes :
- réalisation de la couche d'arrêt de gravure sur au moins une des faces principales d'au moins un des deux substrats,
- solidarisation des deux substrats par l'intermédiaire de la couche d'arrêt de gravure.

La couche d'arrêt de gravure peut être réalisée par une oxydation thermique des deux substrats, pouvant former une couche à base d'oxyde au moins sur les faces principales des deux substrats, et/ou la solidarisation des deux substrats peut être réalisée par un collage et un scellement thermique des deux substrats.

Le procédé peut comporter en outre, entre la réalisation de la couche d'arrêt de gravure et la solidarisation des deux substrats, un nettoyage chimique des surfaces des deux substrats.

Le procédé peut comporter en outre, après la gravure de l'emplacement avec arrêt sur la couche d'arrêt de gravure, une étape de gravure de la couche d'arrêt de gravure se trouvant dans l'emplacement telle que la paroi de fond de l'emplacement soit formée par au moins une partie du second des deux substrats.

L'empilement peut comporter en outre au moins une couche supplémentaire de matériau disposée entre la couche d'arrêt de gravure et le second des deux substrats, le procédé pouvant comporter en outre, après la gravure de l'emplacement avec arrêt sur la couche d'arrêt de gravure, une étape de gravure de la couche d'arrêt de gravure se trouvant dans l'emplacement telle que la paroi de fond de l'emplacement soit formée par au moins une partie de la couche supplémentaire de matériau.

Ainsi, il est possible que la paroi de fond de l'emplacement soit formée soit par la couche d'arrêt de gravure, soit par le second des deux substrats, ou bien par une autre couche disposée entre la couche d'arrêt de gravure et le second substrat. Ce choix peut être réalisé en fonction de la nature et des propriétés souhaitées concernant le matériau destiné à former la paroi de fond de l'emplacement. Ainsi, le matériau formant la paroi de fond de l'emplacement peut être un bon isolant thermique, et par exemple à base d'oxyde de silicium. Cet oxyde de silicium peut être le matériau de la couche d'arrêt de gravure qui peut être obtenue par oxydation thermique des substrats lorsqu'ils sont à base de silicium. Dans un autre cas, le matériau formant la paroi de fond de l'emplacement peut être un bon conducteur thermique, et par exemple à base de silicium. Ce silicium peut être le matériau du second substrat révélé en gravant la couche d'arrêt de gravure se trouvant au fond de l'emplacement, ou bien lorsque le silicium du second substrat forme le matériau d'arrêt de gravure (par exemple lorsque le premier substrat est à base de verre). Dans un autre cas, le matériau formant la paroi de fond de l'emplacement peut être électriquement conducteur afin de faciliter une évacuation de charges électriques depuis le substrat disposé dans l'emplacement. Ce matériau électriquement conducteur peut être par exemple disposé dans l'emplacement par un dépôt réalisé après la gravure de l'emplacement.

La conduction thermique ou électrique entre le matériau formant la paroi de fond de l'emplacement et le substrat disposé dans l'emplacement peut être augmentée lorsque le substrat est collé, par exemple par collage direct, au fond de l'emplacement.

La gravure de l'emplacement peut être réalisée par une première gravure partielle de l'emplacement à travers une partie de l'épaisseur du premier des deux substrats, puis par une seconde gravure par attaque chimique sélective à travers le reste de l'épaisseur du premier des deux substrats et avec arrêt sur le matériau d'arrêt de gravure. En achevant la gravure de l'emplacement par une gravure chimique sélective, on améliore la propreté et la rugosité obtenue au niveau de la paroi de fond de l'emplacement, mais également au niveau des parois latérales de l'emplacement. La première gravure partielle peut être réalisée par divers moyens technologiques : rodage, gravure ionique, attaque chimique, etc.

Avantageusement, la profondeur de l'emplacement peut être sensiblement égale à l'épaisseur du substrat destiné à être supporté par le support.

Le procédé peut comporter en outre, entre la réalisation de l'empilement et la gravure de l'emplacement, la mise en oeuvre d'un amincissement du premier des deux substrats. L'amincissement pouvant être réalisé sur toute la surface du premier substrat, il est possible d'utiliser des procédés standards, tels que le rodage, pour réaliser cet amincissement. Il est ainsi possible de réaliser un emplacement très peu profond, permettant par exemple de manipuler facilement et de traiter des substrats très fins.

Le procédé peut comporter en outre, après la gravure de l'emplacement, un dépôt d'une couche de matériau au moins sur la paroi de fond de l'emplacement.

De manière générale, les couches conductrices ou isolantes, thermiquement et/ou électriquement, peuvent être mises en place au cours de la réalisation de l'empilement ou après la réalisation de l'empilement, par exemple par la réalisation d'un tel dépôt.

Le procédé peut comporter en outre, après la gravure de l'emplacement, une étape de gravure d'une partie du matériau du premier des deux substrats se trouvant en périphérie de l'emplacement telle qu'une portion restante du premier des deux substrats comporte un motif dont une surface intérieure forme des parois latérales de l'emplacement et dont une surface extérieure comporte des dimensions, dans un plan parallèle à l'une des faces principales des deux substrats, inférieures à celles du second des deux substrats. Une telle étape de gravure permet d'alléger le support, par exemple en réduisant la largeur de la couronne définissant le contour de l'emplacement.

Le motif de la portion restante du premier des deux substrats peut notamment comporter une section, dans un plan parallèle à l'une des faces principales des deux substrats, en forme de couronne.

Le procédé peut comporter en outre, après la gravure de l'emplacement, une étape de réalisation d'au moins une ouverture à travers une partie du matériau du premier des deux substrats définissant l'emplacement telle que le contour de l'emplacement soit ouvert. Une telle ouverture permet de faciliter la préhension du substrat lorsqu'il est logé au fond de l'emplacement. Il est possible de pratiquer une ou plusieurs ouvertures depuis l'intérieur de l'emplacement jusqu'à l'extérieure de l'emplacement, par exemple en gravant une partie du matériau du premier substrat jusqu'au matériau d'arrêt de gravure. Cette ou ces ouvertures peuvent permettre, par exemple, le passage d'une precelle à vide ou d'un robot pour saisir le substrat disposé dans l'emplacement. Ainsi, l'emplacement peut n'être défini que par des portions restantes de matériau réparties sur le second substrat selon un motif initial, par exemple une couronne.

Le support peut comporter un emplacement destiné à recevoir un substrat, ou plusieurs emplacements répartis sur la surface du support et aptes à recevoir plusieurs substrats.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 5B représentent les étapes d'un procédé de réalisation d'un support de substrat, objet de la présente invention, selon un mode de réalisation particulier,
- les figures 6A et 6B représentent un support de substrat réalisé selon un procédé, objet de la présente invention, selon une variante du mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

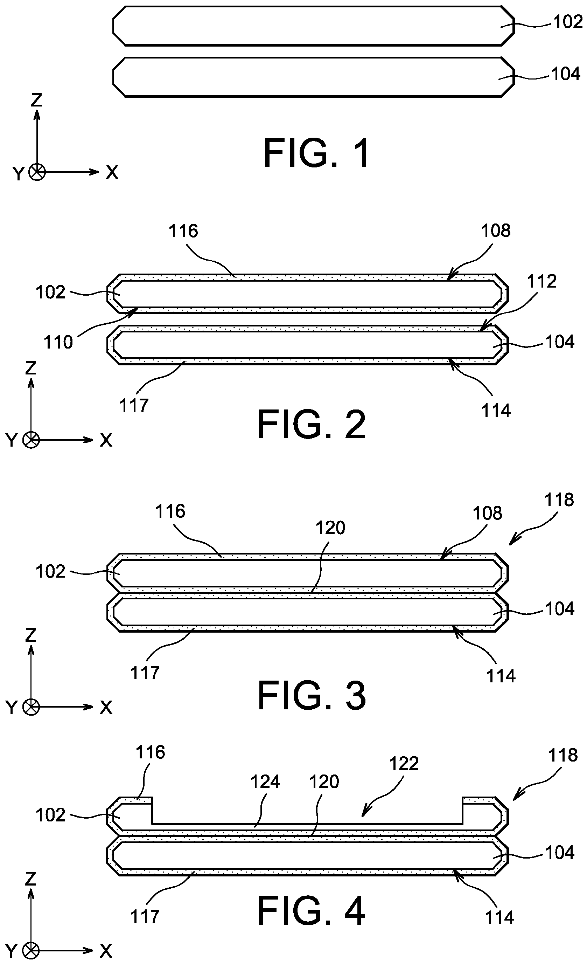

On se réfère aux figures 1 à 5B qui représentent les étapes d'un procédé de réalisation d'un support de substrat 100 selon un mode de réalisation particulier.

Ce support 100 est destiné à recevoir un substrat, par exemple à base de silicium, de diamètre égal à 200 mm afin de pouvoir traiter ce substrat dans une ou plusieurs machines fonctionnant normalement avec des substrats de silicium de 300 mm de diamètre. Le substrat destiné à être supporté par le support 100 peut avoir un diamètre compris entre environ 50 mm et 300 mm et une épaisseur comprise entre environ 5 µm et 750 µm.

Comme représenté sur la figure 1, un premier substrat 102 et un second substrat 104 vont être utilisés pour réaliser le support 100. Les deux substrats 102 et 104 sont ici à base de silicium monocristallin et comportent chacun un diamètre égal à environ 300 mm et une épaisseur égale à environ 750 µm. De manière générale, le diamètre des substrats 102, 104 utilisés pour réaliser le support 100 pourra être par exemple compris entre environ 100 mm et 450 mm, et choisi en fonction des dimensions du ou des substrats destinés à être supportés par le support 100. De même, l'épaisseur des deux substrats pourra être par exemple comprise entre environ 525 µm et 1000 µm, et choisie notamment en fonction de l'épaisseur du ou des substrats destinés à être supportés. Enfin, les substrats 102, 104 peuvent être à base de Si, de Ge, d'AsGa, d'InP, de saphir, de SiC, de silice fondue, de verre ou encore de GaN. De plus, les premier et second substrats 102, 104 peuvent être ou non à base du ou des mêmes matériaux.

Ces deux substrats 102, 104 sont tout d'abord oxydés thermiquement, formant des couches 116, 117 à base d'oxyde de silicium en surface des substrats 102, 104 (figure 2). Ces couches 116, 117 ont par exemple une épaisseur égale à environ 150 nm et sont ici obtenues en traitant thermiquement les deux substrats 102, 104 à 950°C sous atmosphère oxydante.

Le premier substrat 102 comporte donc deux faces principales 108, 110 opposées et recouvertes par la couche d'oxyde de silicium 116. De manière analogue, le second substrat 104 comporte deux faces principales 112, 114 opposées et recouvertes par la couche d'oxyde de silicium 117.

Afin de préparer le collage entre les deux substrats 102, 104, on réalise un nettoyage des surfaces des substrats 102, 104, c'est-à-dire ici des surfaces de couches d'oxyde de silicium 116, 117 étant donné que l'ensemble de la surface des substrats 102, 104 est recouverte par ces couches 116, 117. Un tel nettoyage est par exemple réalisé de manière chimique en utilisant une première solution de type H₂SO₄/H₂O₂ 3:1 à une température égale à environ 180°C pendant environ 10 mn. On réalise ensuite un rinçage à l'eau dé-ionisée (eau DI) pendant une durée égale à environ 10 mn. Une seconde solution de type NH₄OH/H₂O_{2/}H₂O 1:1:5 est ensuite utilisée à une température égale à environ 70°C pendant environ 10 mn. Un second rinçage à l'eau DI est enfin réalisé pendant une durée égale à environ 10 mn.

Comme représenté sur la figure 3, les deux substrats 102 et 104 sont solidarisés l'un à l'autre par collage direct en mettant en contact les couches 116 et 117 à base d'oxyde de silicium et en réalisant un recuit de l'ensemble à une température par exemple égale à environ 1100°C pendant une durée égale à environ 2 heures. Les deux substrats 102, 104 ainsi solidarisés par l'intermédiaire des couches d'oxyde 116, 117 forment un assemblage 118 à partir duquel va être réalisé le support de substrat 100. Les portions des couches d'oxyde de silicium 116, 117 se trouvant entre les faces 110 et 112 des substrats 102, 104 forment ici une couche 120 d'oxyde de silicium disposée entre les deux substrats 102, 104. Cette couche 120 va servir par la suite de couche d'arrêt de gravure lors de la gravure du ou des emplacements dans lesquels le ou les substrats à supporter seront destinés à être disposés. Il est également possible que les deux substrats 102, 104 par un collage anodique ou un collage eutectique.

De manière générale, le matériau d'arrêt de gravure utilisé pourra être à base d'oxyde de silicium, de nitrure de silicium, d'un alliage de silicium-germanium, de germanium, de silicium, ou à base de tout matériau de type III-V et/ou II-VI du moment que le matériau du premier substrat 102 puisse être gravé sélectivement par rapport au matériau d'arrêt de gravure. De plus, il est également possible que plusieurs couches d'arrêt de gravure soient disposées entre le premier et le second substrat 102, 104.

Dans une variante, il est possible de réaliser, après le collage des deux substrats 102, 104 entre eux, un amincissement du premier substrat 102 sur l'ensemble de sa surface. Un tel amincissement correspond ici à supprimer la portion de la couche d'oxyde de silicium 116 se trouvant au-dessus de la face supérieure 108 du premier substrat 102, puis à amincir le premier substrat 102 depuis la face supérieure 108. Un tel amincissement est intéressant à mettre en oeuvre lorsque le substrat destiné à être supporté par le support 100 a une faible épaisseur, afin d'ajuster par exemple l'épaisseur du premier substrat 102 à l'épaisseur du substrat destiné à être supporté. Le premier substrat 102 aminci peut donc avoir une épaisseur comprise entre environ 5 µm et l'épaisseur initiale du premier substrat 102.

On réalise ensuite dans l'assemblage 118 un emplacement 122, ou empreinte, dont le motif correspond sensiblement à la forme du substrat de qui sera destiné à être supporté par le support 100. Cet emplacement 122 a ici une section, dans le plan (X,Y) représenté sur la figure 4, de forme correspondante à celle du substrat à supporter, c'est-à-dire une forme de disque, et a un diamètre légèrement supérieur à celui du substrat destiné à être disposé dans l'emplacement 122, et par exemple égal à environ 201 mm (substrat à supporter de diamètre égal à 200 mm). Dans un premier temps, l'emplacement 122 n'est pas réalisé à travers la totalité de l'épaisseur du premier substrat 102, mais à travers une partie de l'épaisseur du premier substrat 102, par exemple environ 90 % de l'épaisseur du premier substrat 102. Ainsi, une partie 124 du premier substrat 102, dont l'épaisseur correspond à environ 10 % de l'épaisseur totale du premier substrat 102, forme temporairement la paroi de fond de l'emplacement 122.

Cette première gravure de l'emplacement 122 dans le premier substrat 102 est par exemple réalisée par rodage centré avec le centre de l'assemblage 118, tout d'abord à travers la couche d'oxyde de silicium 116, puis dans le premier substrat 102 à partir de la face supérieure 108 du premier substrat 102, par une machine d'amincissement mécanique comportant une roue de rectification. Comme représenté sur la figure 4, ce rodage est achevé avant d'atteindre la couche d'arrêt de gravure 120.

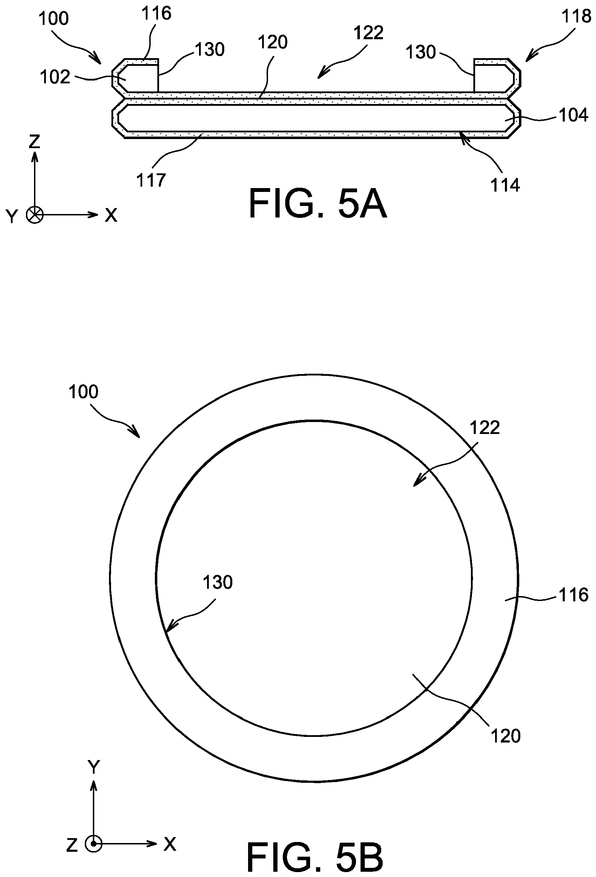

Ensuite, l'emplacement 122 est achevé en réalisant une seconde gravure, ici une gravure chimique sélective, par exemple une gravure au TMAH (Tetraméthyl Ammonium hydroxyde) à une température égale à environ 80°C, permettant de supprimer la partie 124 du premier substrat 102, sans graver le reste de l'assemblage 118 protégé par les couches d'oxyde 116, 117, et en s'arrêtant sur la couche d'oxyde de silicium 120 utilisée donc ici comme couche d'arrêt de gravure (voir figure 5A). Etant donné que la gravure est achevée sur la couche d'arrêt 120, la rugosité et la planéité de la paroi de fond de l'emplacement 122 sont quasi-parfaites. Il n'y a pas non plus, dans l'emplacement 122, de reste de silicium rodé, évitant la génération de particules au fond de l'emplacement 122. De plus, étant donné que lors de cette gravure chimique sélective, les parois latérales de l'emplacement 122 ne sont pas protégées par l'oxyde de silicium des couches 116, 117, ces parois latérales sont également attaquées chimiquement, par exemple sur une profondeur de gravure égale à environ 100 µm, ce qui permet également de retirer la zone écrouie laissée après la réalisation du rodage au niveau des parois latérales de l'emplacement 122 et d'obtenir les mêmes caractéristiques en termes de rugosité et de planéité aussi bien au niveau de la paroi de fond que des parois latérales 130 de l'emplacement 122.

Le support de substrat 100 ainsi réalisé est également représenté vue de dessus sur la figure 5B.

Dans l'exemple précédemment décrit, la paroi de fond de l'emplacement 122 est formée par la couche d'arrêt de gravure 120. Dans une variante de réalisation, il est possible de graver la partie de la couche d'arrêt de gravure 120 qui forme la paroi de fond de l'emplacement 122 afin de révéler la surface du second substrat 104. Ainsi, la paroi de fond de l'emplacement 122 est dans ce cas formée par le second substrat 104.

Dans une autre variante, il est possible qu'au cours de la réalisation de l'empilement 118, une couche d'un autre matériau soit disposée entre la couche d'arrêt de gravure 120 et le second substrat 104. Ainsi, il est possible de graver la partie de la couche d'arrêt de gravure 120 qui forme la paroi de fond de l'emplacement 122 afin de révéler une surface de cette couche de matériau qui forme alors la paroi de fond de l'emplacement 122.

Enfin, dans une autre variante, il est également possible de réaliser, après avoir achevé les gravures formant l'emplacement 122, un ou plusieurs dépôt de matériaux dans l'emplacement 122 afin que le ou les matériaux déposés forment la paroi de fond de l'emplacement 122.

Le choix de l'une ou l'autre de ces variantes pourra se faire en fonction de la nature du matériau souhaité au fond de l'emplacement 122, par exemple si l'on souhaite que les parois de l'emplacement présentent des propriétés de conduction ou d'isolement, thermique et/ou électrique.

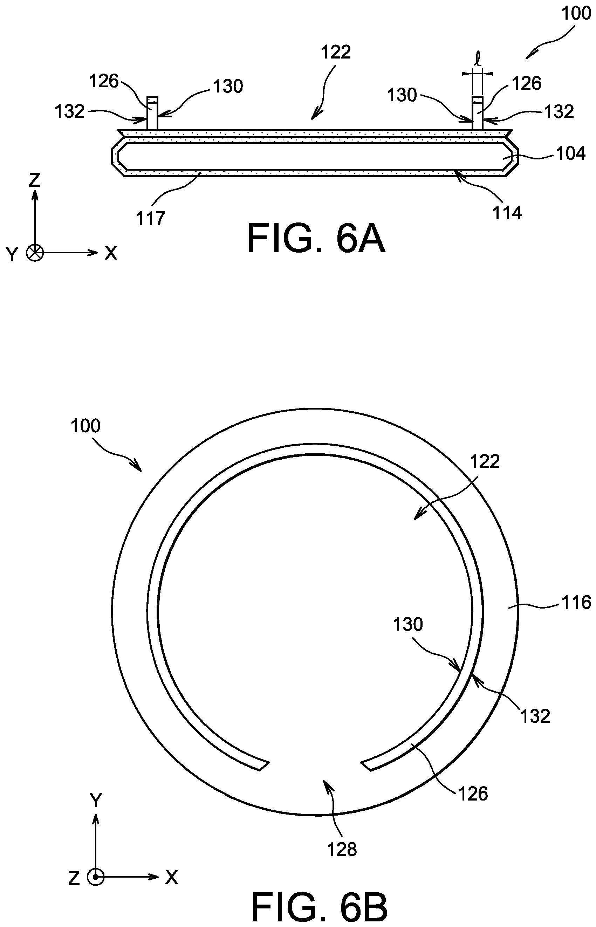

Dans une autre variante du mode de réalisation précédemment décrit, et afin d'alléger le support de substrat 100, il est possible réaliser par rectification, ou par photolithographie et gravure, une gravure supplémentaire du premier substrat 102, en périphérie de l'emplacement 122 et tel que représenté sur la figure 6A. Ainsi, après la mise en oeuvre d'une telle gravure, une portion restante 126 du premier substrat 102 forme une couronne délimitant l'emplacement 122. Cette couronne présente une largeur (référencée 1 sur la figure 6A) par exemple égale à environ 5 mm. Ainsi, dans un tel support 100, plus de 97 % de la matière initiale du premier substrat 102 est enlevée, ce qui allège considérablement le support de substrat 100 sans le fragiliser étant donné que le second substrat 104 est conservé intact.

Afin de faciliter la préhension du substrat destiné à être disposé dans l'emplacement 122, il est possible de réaliser, comme représenté sur la figure 6B, une ouverture 128 dans la couronne formée par la portion restante 126 du premier substrat 102. Cette ouverture 128 peut être réalisée par photolithographie et gravure, ou avantageusement par rectification afin de limiter le nombre d'étapes technologiques pour former cette ouverture 128. Bien qu'une seule ouverture 128 soit représentée sur l'exemple de la figure 6B, il est également possible que plusieurs ouvertures 128 soient formées à travers la couronne 126. Ainsi, plusieurs portions disjointes de matériaux forment le contour de l'emplacement dans lequel un substrat est destiné à être disposé.

Dans les exemples décrits précédemment, les substrats utilisés, à la fois ceux à partir desquels le support 100 est réalisé et celui destiné à être supporté par le support 100, ont une forme cylindrique (section en forme de disque). Toutefois, le procédé peut s'appliquer à des substrats de formes autres que cylindriques. De plus, il est également possible que les deux substrats 102 et 104 à partir desquels le support 100 est réalisé peuvent être de dimensions différentes, le premier substrat 102 dans lequel est réalisé l'emplacement pouvant avoir des dimensions (par exemple un diamètre) inférieures à celles du second substrat 104.

De plus, il est également possible que la couche d'arrêt de gravure soit réalisée différemment que dans l'exemple précédemment décrit. Il est par exemple possible que la couche d'arrêt de gravure soit formée sur une des faces principales d'un des deux substrats 102, 104 seulement.

En choisissant deux substrats 102, 104 à base de deux matériaux différents, le premier substrat 102 étant par exemple à base de verre et le second substrat 104 étant par exemple à base de silicium, la surface du second substrat 104 peut servir de couche d'arrêt de gravure. Dans ce cas, l'emplacement 122 pourra être réalisé par gravure chimique en utilisant une solution à base d'acide fluorhydrique qui grave très rapidement le verre sans graver le silicium.

## Revendications

1. Procédé de réalisation d'un support (100) d'au moins une plaquette, comportant au moins la mise en oeuvre des étapes suivantes :
- réalisation d'un empilement (118) comportant au moins deux substrats (102, 104), chacun des deux substrats (102, 104) comprenant deux faces principales (108, 110, 112, 114) opposées, les deux substrats étant solidarisés l'un à l'autre tels qu'une des faces principales (110) d'un premier (102) des deux substrats soit disposée en regard d'une des faces principales (112) du second (104) des deux substrats et contre un matériau d'arrêt de gravure,
- gravure, à travers le premier (102) des deux substrats et avec arrêt sur le matériau d'arrêt de gravure, d'au moins un emplacement (122) apte à recevoir la plaquette destinée à être supportée par le support (100).

2. Procédé selon la revendication 1, dans lequel les deux substrats (102, 104) sont solidarisés par un collage direct ou par un collage anodique ou par un collage eutectique.

3. Procédé selon l'une des revendications précédentes, dans lequel les deux substrats (102, 104) ont des épaisseurs sensiblement similaires et/ou des sections, dans un plan sensiblement parallèle à l'une des faces principales (108, 110, 112, 114) des deux substrats (102, 104), de dimensions sensiblement similaires.

4. Procédé selon l'une des revendications précédentes, dans lequel les deux substrats (102, 104) ont des sections, dans un plan parallèle à l'une des faces principales (108, 11C, 112, 114) des deux substrats (102, 104), en formes de disques, et dans lequel une section de l'emplacement (122), dans un plan parallèle à l'une des faces principales (108, 110, 112, 114) des deux substrats (102, 104), a une forme de disque de diamètre inférieur aux diamètres desdites sections des deux substrats (102, 104).

5. Procédé selon l'une des revendications précédentes, dans lequel le premier (102) des deux substrats est à base d'au moins un matériau apte à être gravé sélectivement par rapport à au moins un matériau du second (104) des deux substrats formant le matériau d'arrêt de gravure.

6. Procédé selon l'une des revendications 1 à 4, dans lequel l'empilement (113) comporte en outre une couche d'arrêt de gravure (128) disposée entre les deux substrats (102, 104).

7. Procédé selon la revendication 6, dans lequel l'empilement (113) est réalisé par la mise en oeuvre des étapes suivantes :
- réalisation de la couche d'arrêt de gravure (120) sur au moins une des faces principales (110, 112) d'au moins un des deux substrats (102, 104),
- solidarisation des deux substrats (102, 104) par l'intermédiaire de la couche d'arrêt de gravure (120).

8. Procédé selon la revendication 7, dans lequel la couche d'arrêt de gravure (120) est réalisée par une oxydation thermique des deux substrats (102, 104), formant une couche (116, 117 à base d'oxyde au moins sur les faces principales (108, 110, 112, 114) des deux substrats (102, 104), et/ou dans lequel la solidarisation des deux substrats (102, 104) est réalisée par un collage et un scellement thermique des deux substrats (102, 104).

9. Procédé selon l'une des revendications 7 ou 8, comportant en outre, entre la réalisation de la couche d'arrêt de gravure (120) et la solidarisation des deux substrats (102, 104), un nettoyage chimique des surfaces des deux substrats (102, 104).

10. Procédé selon l'une des revendications 6 à 9, comportant en outre, après la gravure de l'emplacement (122) avec arrêt sur la couche d'arrêt de gravure (120), une étape de gravure de la couche d'arrêt de gravure (120) se trouvant dans l'emplacement (122) telle que la paroi de fond de l'emplacement (122) soit formée par au moins une partie du second des deux substrats (104).

11. Procédé selon l'une des revendications 6 à 9, dans lequel l'empilement (118) comporte en outre au moins une couche supplémentaire de matériau disposée entre la couche d'arrêt de gravure (120) et le second des deux substrats (104), le procédé comportant en outre, après la gravure de l'emplacement (122) avec arrêt sur la couche d'arrêt de gravure (120), une étape de gravure de la couche d'arrêt de gravure (120) se trouvant dans l'emplacement (122) telle que la paroi de fond de l'emplacement (122) soit formée par au moins une partie de la couche supplémentaire de matériau.

12. Procédé selon l'une des revendications précédentes, dans lequel la gravure de l'emplacement (122) est réalisée par une première gravure partielle de l'emplacement (122) à travers une partie de l'épaisseur du premier des deux substrats (102), puis par une seconde gravure par attaque chimique sélective à travers le reste (124) de l'épaisseur du premier des deux substrats (102) et avec arrêt sur le matériau d'arrêt de gravure.

13. Procédé selon l'une des revendications précédentes, dans lequel la profondeur de l'emplacement (122) est sensiblement égale à l'épaisseur du substrat destiné à être supporté par le support (100).

14. Procédé selon l'une des revendications précédentes, comportant en outre, entre la réalisation de l'empilement (118) et la gravure de l'emplacement (122), la mise en oeuvre d'un amincissement du premier des deux substrats (102).

15. Procédé selon l'une des revendications précédentes, comportant en outre, après la gravure de l'emplacement (122), un dépôt d'une couche de matériau au moins sur la paroi de fond de l'emplacement (122).

16. Procédé selon l'une des revendications précédentes, comportant en outre, après la gravure de l'emplacement (122), une étape de gravure d'une partie du matériau du premier des deux substrats (102) se trouvant en périphérie de l'emplacement (122) telle qu'une portion restante (126) du premier des deux substrats (102) comporte un motif dont une surface intérieure (130) forme ces parois latérales de l'emplacement (122) et dont une surface extérieure (132) comporte des dimensions, dans un plan parallèle à l'une des faces principales (108, 110, 112, 114) des deux substrats (102, 104), inférieures à celles du second des deux substrats (104).

17. Procédé selon la revendication 16, dans lequel le motif de la portion restante (126) du premier des deux substrats (102) comporte une section, dans un plan parallèle à l'une des faces principales (108, 110, 112, 114) des deux substrats (102, 104), en forme de couronne.

18. Procédé selon l'une des revendications précédentes, comportant en outre, après la gravure de l'emplacement (122), une étape de réalisation d'au moins une ouverture (128) à travers une partie (126) du matériau du premier des deux substrats (102) définissant l'emplacement (122) telle que le contour de l'emplacement (122) soit ouvert.

## Patentansprüche

1. Verfahren zum Herstellen eines Trägers (100) für zumindest einen Wafer, das zumindest die Ausführung der nachstehenden Schritte umfasst:
- Ausbilden einer Stapelung (118), die zumindest zwei Substrate (102, 104) enthält, wobei jedes der beiden Substrate (102, 104) zwei entgegengesetzte Hauptflächen (108, 110, 112, 114) aufweist, wobei die beiden Substrate so miteinander verbunden sind, dass eine der Hauptflächen (110) eines ersten (102) der beiden Substrate gegenüber einer der Hauptflächen (112) des zweiten (104) der beiden Substrate und an einem Ätzstoppmaterial zu liegen kommt,
- Ätzen zumindest einer Stelle (122), die zur Aufnahme des Wafers geeignet ist, der von dem Träger (100) getragen werden soll, durch das erste (102) der beiden Substrate hindurch und mit Stopp an dem Ätzstoppmaterial.

2. Verfahren nach Anspruch 1, wobei die beiden Substrate (102, 104) durch direktes Bonden oder durch anodisches Bonden oder eutektisches Bonden miteinander verbunden werden.

3. Verfahren nach einem der vorangehenden Ansprüche, wobei die beiden Substrate (102, 104) in einer Ebene, die im Wesentlichen parallel zu einer der Hauptflächen (108, 110, 112, 114) der beiden Substrate (102, 104) verläuft, im Wesentlichen ähnliche Dicken und/oder Querschnitte mit im Wesentlichen ähnlichen Abmessungen aufweisen.

4. Verfahren nach einem der vorangehenden Ansprüche, wobei die beiden Substrate (102, 104) in einer Ebene, die im Wesentlichen parallel zu einer der Hauptflächen (108, 110, 112, 114) der beiden Substrate (102, 104) verläuft, Querschnitte in Form von Scheiben haben, und wobei ein Querschnitt der Stelle (122) in einer Ebene, die im Wesentlichen parallel zu einer der Hauptflächen (108, 110, 112, 114) der beiden Substrate (102, 104) verläuft, eine Scheibenform mit einem Durchmesser hat, der kleiner als die Durchmesser der Querschnitte der beiden Substrate (102, 104) sind.

5. Verfahren nach einem der vorangehenden Ansprüche, wobei das erste (102) der beiden Substrate auf Basis zumindest eines Materials besteht, das dazu geeignet ist, selektiv bezüglich zumindest eines Materials des zweiten (104) der beiden Substrate geätzt zu werden, das das Ätzstoppmaterial bildet.

6. Verfahren nach einem der Ansprüche 1 bis 4, wobei die Stapelung (118) ferner eine Ätzstoppschicht (120) enthält, die zwischen den beiden Substraten (102, 104) angeordnet ist.

7. Verfahren nach Anspruch 6, wobei die Stapelung (118) durch Ausführen der nachstehenden Schritte hergestellt wird:
- Bilden der Ätzstoppschicht (120) an zumindest einer der Hauptflächen (110, 112) zumindest eines der beiden Substrate (102, 104),
- Verbinden der beiden Substrate (102, 104) über die Ätzstoppschicht (120).

8. Verfahren nach Anspruch 7, wobei die Ätzstoppschicht (120) durch thermische Oxidation der beiden Substrate (102, 104) unter Bildung einer oxidbasierten Schicht (116, 117) zumindest an den Hauptflächen (108, 110, 112, 114) der beiden Substrate (102, 104) ausgebildet wird, und/oder wobei die Verbindung der beiden Substrate (102, 104) durch Bonden und thermisches Versiegeln der beiden Substrate (102, 104) gebildet wird.

9. Verfahren nach einem der Ansprüche 7 oder 8, ferner umfassend zwischen dem Ausbilden der Ätzstoppschicht (120) und dem Verbinden der beiden Substrate (102, 104) ein chemisches Reinigen der Oberflächen der beiden Substrate (102, 104).

10. Verfahren nach einem der Ansprüche 6 bis 9, ferner umfassend nach dem Ätzen der Stelle (122) mit Stopp an der Ätzstoppschicht (120) einen Schritt des Ätzens der Ätzstoppschicht (120), die sich an der Stelle (122) befindet, so dass die Bodenwand der Stelle (122) durch zumindest einen Teil des zweiten der beiden Substrate (104) gebildet wird.

11. Verfahren nach einem der Ansprüche 6 bis 9, wobei die Stapelung (118) ferner zumindest eine zusätzliche Materialschicht enthält, die zwischen der Ätzstoppschicht (120) und dem zweiten der beiden Substrate (104) angeordnet ist, wobei das Verfahren ferner nach dem Ätzen der Stelle (122) mit Stopp an der Ätzstoppschicht (120) einen Schritt des Ätzens der Ätzstoppschicht (120) umfasst, die sich an der Stelle (122) befindet, so dass die Bodenwand der Stelle (122) durch zumindest einen Teil der zusätzlichen Materialschicht gebildet wird.

12. Verfahren nach einem der vorangehenden Ansprüche, wobei das Ätzen der Stelle (122) durch ein erstes Teilätzen der Stelle (122) durch einen Teil der Dicke des ersten der beiden Substrate (102) hindurch, dann durch ein zweites Ätzen durch selektives chemisches Ätzen durch die restliche Dicke (124) des ersten der beiden Substrate (102) hindurch und mit Stopp an dem Ätzstoppmaterial erfolgt.

13. Verfahren nach einem der vorangehenden Ansprüche, wobei die Tiefe der Stelle (122) im Wesentlichen gleich der Dicke des Substrats ist, das von dem Träger (100) getragen werden soll.

14. Verfahren nach einem der vorangehenden Ansprüche, ferner umfassend zwischen dem Ausbilden der Stapelung (118) und dem Ätzen der Stelle (122) das Ausführen einer Verjüngung des ersten der beiden Substrate (102).

15. Verfahren nach einem der vorangehenden Ansprüche, ferner umfassend nach dem Ätzen der Stelle (122) ein Abscheiden einer Materialschicht zumindest auf die Bodenwand der Stelle (122).

16. Verfahren nach einem der vorangehenden Ansprüche, ferner umfassend nach dem Ätzen der Stelle (122) einen Schritt des Ätzens eines Teils von dem Material des ersten der beiden Substrate (102), der sich am Umfang der Stelle (122) befindet, so dass ein Restabschnitt (126) des ersten der beiden Substrate (102) ein Muster aufweist, von dem eine Innenfläche (130) Seitenwände der Stelle (122) bildet und von dem eine Außenfläche (132) in einer Ebene parallel zu einer der Hauptflächen (108, 110, 112, 114) der beiden Substrate (102, 104) Abmessungen aufweist, die geringer als die des zweiten der beiden Substrate (104) sind.

17. Verfahren nach Anspruch 16, wobei das Muster des Restabschnitts (126) des ersten der beiden Substrate (102) in einer Ebene parallel zu einer der Hauptflächen (108, 110, 112, 114) der beiden Substrate (102, 104) einen kranzförmigen Querschnitt aufweist.

18. Verfahren nach einem der vorangehenden Ansprüche, ferner umfassend nach dem Ätzen der Stelle (122) einen Schritt des Ausbildens zumindest einer Öffnung (128) durch einen Teil (126) des Materials des ersten der beiden Substrate (102) hindurch, welche die Stelle (122) definiert, so dass die Kontur der Stelle (122) offen ist.

## Claims

1. Method for making a support (100) of at least one substrate, including at least the implementation of the following steps:
- making a stack (118) including at least two substrates (102, 104), each of the two substrates (102, 104) comprising two opposite main faces (108, 110, 112, 114), both substrates being secured to each other such that one of the main faces (110) of a first (102) of the two substrates is positioned facing one of the main faces (112) of the second (104) of the two substrates and against an etch-stop material,
- etching through the first (102) of the two substrates and with stop on the etch-stop material, at least one location (122) which is able to receive the substrate intended to be supported by the support (100).

2. Method according to claim 1, wherein both substrates (102, 104) are secured to each other by direct bonding or by anodic bonding or by eutectic bonding.

3. Method according to one of the preceding claims, wherein both substrates (102, 104) have substantially similar thicknesses and/or sections in a plane substantially parallel to one of the main faces (108, 110, 112, 114) of the two substrates (102, 104) of substantially similar dimensions.

4. Method according to one of the preceding claims, wherein both substrates (102, 104) have disk-shaped sections, in a plane parallel to one of the main faces (108, 110, 112, 114) of the two substrates (102, 104) and wherein a section of the location (122), in a plane parallel to one of the main faces (108, 110, 112, 114) of the two substrates (102, 104) has the shape of a disk with a diameter smaller than the diameters of said sections of both substrates (102, 104).

5. Method according to one of the preceding claims, wherein the first (102) of the two substrates comprises at least one material able to be selectively etched relatively to at least one material of the second (104) of the two substrates, forming the etch-stop material.

6. Method according to one of claims 1 to 4, wherein the stack (118) further includes an etch-stop layer (120) positioned between both substrates (102, 104) .

7. Method according to claim 6, wherein the stack (118) is made by applying the following steps:
- making the etch-stop layer (120) on at least one of the main faces (110, 112) of at least one of the two substrates (102, 104),
- securing both substrates (102, 104) together via the etch-stop layer (120).

8. Method according to claim 7, wherein the etch-stop layer (120) is made by thermal oxidation of both substrates (102, 104), forming an oxide-based layer (116, 117) at least on the main faces (108, 110, 112, 114) of the two substrates (102, 104), and/or wherein the securing of both substrates (102, 104) is achieved by bonding and heat-sealing of both substrates (102, 104) .

9. Method according to one of claims 7 or 8, further including, between the making of the etch-stop layer (120) and the securing of both substrates (102, 104), chemical cleaning of the surfaces of both substrates (102, 104).

10. Method according to one of claims 6 to 9, further including, after etching the location (122) with stop on the etch-stop layer (120), a step for etching the etch-stop layer (120) found in the location (122) such that the bottom wall of the location (122) is formed by at least one portion of the second of the two substrates (104).

11. Method according to one of claims 6 to 9, wherein the stack (118) further includes at least one additional material layer positioned between the etch-stop layer (120) and the second of the two substrates (104), the method further including, after etching the location (122) with stop on the etch-stop layer (120), a step for etching the etch-stop layer (120) found in the location (122) such that the bottom wall of the location (122) is formed by at least one portion of the additional material layer.

12. Method according to one of the preceding claims, wherein the etching of the location (122) is achieved by first partial etching of the location (122) through a portion of the thickness of the first of the two substrates (102), and then by second etching with selective chemical etching through the remainder (124) of the thickness of the first of the two substrates (102) and with stop on the etch-stop material.

13. Method according to one of the preceding claims, wherein the depth of the location (122) is substantially equal to the thickness of the substrate intended to be supported by the support (100).

14. Method according to one of the preceding claims, further including, between the making of the stack (118) and the etching of the location (122), the implementation of thinning to the first of the two substrates (102).

15. Method according to one of the preceding claims, further including, after etching of the location (122), a deposition of a material layer at least on the bottom wall of the location (122).

16. Method according to one of the preceding claims, further including, after etching of the location (122), a step for etching a portion of the material of the first of the two substrates (102) found at the periphery of the location (122) such that a remaining portion (126) of the first of the second substrates (102) includes a pattern, an inner surface of which (130) forms side walls of the location (122) and an outer surface of which (132), in a plane parallel to one of the main faces (108, 110, 112, 114) of both substrates (102, 104), includes dimensions smaller than those of the second of the two substrates (104).

17. Method according to claim 16, wherein the pattern of the remaining portion (126) of the first of the two substrates (102) includes a crown-shaped section, in a plane parallel to one of the main faces (108, 110, 112, 114) of the two substrates (102, 104).

18. Method according to one of the preceding claims, further including, after the etching of the location (122), a step for making at least one aperture (128) through a portion (126) of the material of the first of the two substrates (102) defining the location (122) such that the contour of the location (122) is open.
